# EUROPEAN PATENT APPLICATION

(11) **EP 4 644 916 A1**
(43) Date of publication of application: **05.11.2025**
(21) Application number: 24850370.8
(22) Date of filing: 28.10.2024
(51) Int. Cl.: G01R 19/00, G01R 15/24, G01R 33/00

(54) **QUANTUM SENSING MODULE, QUANTUM CURRENT TRANSFORMER, AND CURRENT MEASUREMENT METHOD**

(30) Priority: 14.03.2024 CN 202410289213
(71) Applicant: State Grid Anhui Electric Power Research Institute, Hefei, Anhui 230601 (CN)
(72) Inventor: ZHAO, Long, Hefei, Anhui 230601 (CN); ZHAO, Bowen, Hefei, Anhui 230601 (CN); QIU, Rujia, Hefei, Anhui 230601 (CN); ZHANG, Shaochun, Hefei, Anhui 230601 (CN); TIAN, Teng, Hefei, Anhui 230601 (CN); GENG, Jiaqi, Hefei, Anhui 230601 (CN); WANG, Enhui, Hefei, Anhui 230601 (CN); GAO, Bo, Hefei, Anhui 230601 (CN); XIE, Tao, Hefei, Anhui 230601 (CN); LUO, Chao, Hefei, Anhui 230601 (CN); YANG, Haitao, Hefei, Anhui 230601 (CN); HU, Xiaoyu, Hefei, Anhui 230601 (CN)
(74) Representative: Chimini, Francesco
(86) International application number: PCT/CN2024/127756
(87) International publication number: WO 2025/189769

(57) **Abstract**

Provided are a quantum sensing module, a quantum current transformer, and a current measurement method. The quantum sensing module includes a quantum probe (1), a laser unit (2), a microwave unit (3), a photoelectric detection unit (4), a phase-locked amplifier (5), a frequency locking unit (6), and a data processing unit (7). The quantum probe (1) includes a diamond sensing unit (11) and a microwave radiator (12). The laser unit (2) is configured to output an excitation laser. The microwave unit (3) is configured to output a microwave signal. The photoelectric detection unit (4) is configured to receive the photoluminescence produced by the diamond sensing unit (11) and convert the photoluminescence into an output voltage signal. The phase-locked amplifier (5) includes a modulation unit and a demodulation unit. The frequency locking unit (6) includes a PID control unit and a frequency acquisition unit.

## Description

This application claims priority to Chinese Patent Application No. 202410289213.4 filed with the China National Intellectual Property Administration (CNIPA) on Mar. 14, 2024, the disclosure of which is incorporated herein by reference in its entirety.

### TECHNICAL FIELD

The present application relates to the field of quantum precision measurement technology, for example, a quantum sensing module, a quantum current transformer, and a current measurement method.

### BACKGROUND

In recent years, the research and development of solid-state spin defect systems in the field of quantum precision measurement has advanced rapidly, especially in the area of magnetic field detection. This has led to the development of detection methods primarily based on Optically Detected Magnetic Resonance (ODMR). By studying the linear relationship between magnetic resonance frequency and external magnetic fields, it is possible to sense, measure, and quantify external magnetic fields. However, some current research remains theoretical, and many practical application issues still need to be addressed in the process of commercializing related technologies.

Chinese patent CN113804941B discloses a current measurement device and method based on diamond NV centers. The current measurement device includes a laser excitation and reflected light reception analysis system, a diamond NV center probe, a magnetic concentrator, and a microwave excitation device. This transformer includes three measurement methods: full optical measurement, non-full optical measurement, and combined measurement. The application proposes a current measurement method based on ODMR, where the extraction of magnetic resonance frequency is a challenge in practical applications.

In related technologies, methods for extracting a resonance frequency mainly include manual point selection and curve fitting. Both of these methods require a frequency sweep to obtain the ODMR spectrum to extract the resonance frequency, making the process timeconsuming. Additionally, the manual point selection method suffers from low accuracy and inability for commercialization, while the curve fitting method involves complex differentiation processes and has bandwidth limitations on measurement.

### SUMMARY

The present application provides a quantum sensing module, a quantum current transformer, and a current measurement method to solve problems of related technologies.

The present application provides a quantum sensing module. The quantum sensing module includes a quantum probe, a laser unit, a microwave unit, a photoelectric detection unit, a phase-locked amplifier, a frequency locking unit, and a data processing unit.

The quantum probe includes a diamond sensing unit and a microwave radiator. The diamond sensing unit is located in a working area of the microwave radiator. The diamond sensing unit includes a nitrogen-vacancy (NV) center.

The laser unit is configured to output an excitation laser. The excitation laser is configured to irradiate the diamond sensing unit to cause the diamond sensing unit to produce photoluminescence.

The microwave unit is configured to output a microwave signal. The microwave signal is configured to form a microwave field via the microwave radiator to radiate to the diamond sensing unit.

The photoelectric detection unit is configured to receive the photoluminescence produced by the diamond sensing unit and convert the photoluminescence into an output voltage signal.

The phase-locked amplifier includes a modulation unit and a demodulation unit. The modulation unit is configured to output a microwave modulation signal to the microwave unit. The microwave modulation signal is configured to modulate the microwave signal. The demodulation unit is configured to demodulate the voltage signal and output a demodulation result.

The frequency locking unit includes a proportional-integral-derivative (PID) control unit and a frequency acquisition unit. The PID control unit is configured to use the demodulation result as an input value and output a frequency adjustment parameter. The frequency adjustment parameter is configured to adjust a microwave output frequency of the microwave unit. The frequency acquisition unit is configured to read the microwave output frequency of the microwave unit.

The data processing unit is configured to be communicatively connected to the frequency locking unit and the phase-locked amplifier and perform data analysis processing on a target program.

In some embodiments of the present application, the quantum probe includes a transmission optical fiber, and the diamond sensing unit is mounted on a light transmission region at one end face of the transmission optical fiber.

Alternatively, the quantum probe includes two transmission optical fibers that are fused into a single unit, and the diamond sensing unit is mounted on a fused face between the two transmission optical fibers.

In some embodiments of the present application, the phase-locked amplifier is a dual-phase digital demodulator.

According to another aspect of the present application, a quantum current transformer is provided. The quantum current transformer includes the quantum sensing module. The quantum current transformer is configured to measure a current in a conductor. The quantum current transformer also includes a conductor channel. An external magnetic shield is disposed on the outer side of the conductor channel. The diamond sensing unit is disposed on a virtual ring between the conductor channel and the external magnetic shield.

In some embodiments of the present application, multiple quantum sensing modules are disposed in the quantum current transformer, and all diamond sensing units are configured to be evenly spaced on the virtual ring.

In some embodiments of the present application, the diamond sensing unit is a diamond particle including ensemble NV centers, and angles between four NV center axes of the diamond sensing unit and a tangent to the virtual ring at a point where the diamond particle is located are consistent or unequal to each other.

In some embodiments of the present application, the quantum current transformer also includes a magnetic concentrator, and the diamond sensing unit is disposed in a magnetic gap of the magnetic concentrator.

In some embodiments of the present application, 4n quantum sensing modules are provided. n is a positive integer.

In some embodiments of the present application, an internal magnetic shield is also disposed on the outer side of the conductor channel, and the diamond sensing unit is disposed on the outer side of the internal magnetic shield.

In some embodiments of the present application, the quantum current transformer also includes a bias magnetic source. The bias magnetic source is configured to apply a bias magnetic field at any angle to the diamond sensing unit.

In some embodiments of the present application, the quantum current transformer also includes a primary ring. The conductor channel is located in an inner hole of the primary ring. The external magnetic shield and the diamond sensing unit are located in an inner cavity of the primary ring.

In some embodiments of the present application, the quantum current transformer also includes a conductor rod. The central axis of the conductor rod coincides with the central axis of the inner hole of the primary ring. The central axis of the conductor rod is perpendicular to and intersects the center of the virtual ring.

In some embodiments of the present application, the quantum current transformer also includes an insulator. The primary ring is disposed at the top of the insulator. A cable channel is formed in the insulator and passes through the upper side and the lower side of the insulator.

According to another aspect of the present application, a current measurement method is provided. The current measurement method is applied to the quantum current transformer.

The current measurement method includes an initial parameter acquisition operation which includes: outputting, by the microwave unit, a frequency-swept microwave signal, plotting an optical detection magnetic resonance (ODMR) spectrum of the quantum probe based on the frequency-swept microwave signal, acquiring a microwave resonance frequency at a magnetic resonance feature point on the ODMR spectrum, and recording the microwave resonance frequency as an initial microwave frequency. The current measurement method further includes an conductor current measurement operation: outputting, by the microwave unit, a fixed-frequency microwave signal at the initial microwave frequency; outputting, by the phase-locked amplifier, a frequency-modulated signal and modulating the fixed-frequency microwave signal by using the frequency-modulated signal; activating the quantum current transformer based on the fixed-frequency microwave signal to perform ODMR measurement; measuring, by the quantum current transformer, a magnetic field generated by a to-be-measured energized conductor and acquiring a demodulation result; performing, by the PID control unit, feedback adjustment on the microwave unit based on the demodulation result and a target value such that the microwave output frequency of the microwave unit is switched to an available resonance frequency that characterizes the magnetic field generated by the energized conductor; capturing, by the frequency acquisition unit, the available resonance frequency and transmitting the available resonance frequency to the data processing unit; and analyzing and processing, by the data processing unit, the available resonance frequency to obtain current information in the to-be-measured energized conductor.

In some embodiments of the present application, in the current measurement method, acquiring the demodulation result includes outputting, by the photoelectric detection unit, a voltage signal that characterizes the magnetic field generated by the to-be-measured energized conductor; and demodulating the voltage signal by using a dual-phase digital demodulation method to acquire the demodulation result, performing phase adjustment such that one of two demodulated component values is approximately zero, comparing the other of the component values with the target value, where the other of the component values serves as the input value of the PID control unit, and outputting the frequency adjustment parameter for adjusting the microwave unit.

In some embodiments of the present application, the current measurement method further includes automatically adjusting, by a phase auto-adjusting unit of the quantum current transformer, an initial phase of the phase-locked amplifier according to a set target.

In some embodiments of the present application, the current measurement method further includes automatically identifying, by a feature point auto-acquisition unit of the quantum current transformer, the magnetic resonance feature point on the ODMR spectrum and acquiring the microwave resonance frequency at the magnetic resonance feature point.

### BRIEF DESCRIPTION OF DRAWINGS

To illustrate embodiments of the present application, drawings used in description of the embodiments are described below. The drawings described below illustrate part of the embodiments of the present application, and those of ordinary skill in the art may obtain other drawings based on the drawings described below on the premise that no creative work is done.
FIG. 1 is a system diagram of a quantum sensing module according to embodiment one.
FIG. 2 illustrates an ODMR spectrum plotted with a demodulation value R on the vertical axis.
FIG. 3 illustrates an ODMR spectrum plotted with a demodulation Y-component value on the vertical axis.
FIG. 4 is a diagram illustrating the structure of a quantum sensing module according to embodiment one.
FIG. 5 is a diagram illustrating the structure of a quantum probe according to embodiment one.
FIG. 6 is a diagram illustrating the structure of a quantum probe according to embodiment one.
FIG. 7 is a diagram illustrating the structure of a quantum current transformer that includes one quantum sensing module according to embodiment two.
FIG. 8 is a diagram illustrating the structure of a quantum current transformer that includes four quantum sensing modules according to embodiment two.
FIG. 9 is a usage diagram of four quantum sensing modules that use magnetic concentrators according to embodiment two.
FIG. 10 is a diagram of a combination of a primary ring and a conductor rod according to embodiment two.

### DETAILED DESCRIPTION

The embodiments described below with reference to the drawings are illustrative and only for explaining the present application.

One or more embodiments are described with reference to drawings, with similar reference numerals used throughout the drawings to denote similar components. Many details are provided in the description below to facilitate a more thorough understanding of the one or more embodiments. Nevertheless, the one or more embodiments can be practiced without these details and can be combined with each other and reference each other as long as they do not contradict each other.

It is to be noted that terms such as "first" and "second" in the description, claims, and drawings of the present application are used to distinguish between similar objects and are not necessarily used to describe a particular order or sequence. It is to be understood that data used in this manner are interchangeable where appropriate so that the embodiments of the present application described herein can be implemented in an order not illustrated or described herein. Additionally, terms "include" and "have" and any variations thereof are intended to encompass a non-exclusive inclusion. For example, a process, method, system, product or device that includes a series of steps or units not only includes the listed steps or units but may also include other steps or units that are not listed or are inherent to such process, method, product or device.

A nitrogen-vacancy (NV) center in a diamond is a common defect consisting of a nitrogen atom and an adjacent vacancy (that is, a missing carbon atom). This structure uses an unpaired electron in the diamond, making the NV center paramagnetic. Moreover, the NV center can emit photoluminescence when exposed to light, making it significant for optical and electronic application in the diamond. The formation of the NV center in the diamond usually requires certain treatments, such as introducing the nitrogen atom into the diamond lattice through ion implantation or electron beam irradiation, followed by high-temperature annealing to allow the nitrogen atom to combine with the adjacent vacancy. In addition, other impurities and defects in the diamond may affect the properties of the NV center, so high requirements are imposed on the purity and crystal quality of the diamond.

Due to the excellent photoluminescence properties and paramagnetism of NV centers, they have potential applications in fields such as biological labeling, quantum information, and magnetic imaging. For example, NV centers can be used as photoluminescence markers for imaging and detecting cells and tissues as well as qubits for quantum computing and quantum communication. Additionally, because of the paramagnetic nature of NV centers, they can be used for magnetic imaging and the development of magnetic sensors.

When a diamond includes a large number of NV centers (that is, ensemble NV centers), due to the unique structure of the diamond lattice, the randomly oriented NV centers result in four fixed-angle axes for the NV centers. In this case, the ensemble NV centers in the diamond, as a sensing unit, possess vector detection capabilities.

The key to Optically Detected Magnetic Resonance (ODMR) is the use of optical sensitivity and high resolution to detect magnetic resonance signals. In ODMR experiments with diamond NV centers, the first step is to place the NV centers in an external magnetic field so that the atomic nuclei or electron magnetic moments in the NV centers interact with the applied magnetic field. Then, a microwave with a specific frequency is irradiated onto the sample, causing the atomic nuclei or electrons in the NV centers to undergo energy level transitions. These transitions result in the absorption or emission of electromagnetic radiation at certain frequencies, forming a magnetic resonance signal. The magnetic resonance signal is then detected using optical techniques. Through calibration and conversion between the magnetic resonance signal and physical quantities such as the magnetic field, quantum sensing measurement can be achieved.

The so-called ODMR spectrum generally refers to a detection curve obtained by performing ODMR measurement using a frequency sweeping method. (This curve can be divided into two types: modulated and unmodulated. The point on the curve corresponding to the magnetic resonance frequency is called a magnetic resonance feature point. In the modulated ODMR spectrum, the magnetic resonance feature point is a zero-crossing point while in the unmodulated ODMR spectrum, the magnetic resonance feature point is the peak value of the resonance peak.) Since the frequency sweeping method operates with a swept microwave, the time required to draw the spectrum is relatively long, not conducive to quickly extracting feature values for magnetic field calculation.

### Embodiment one

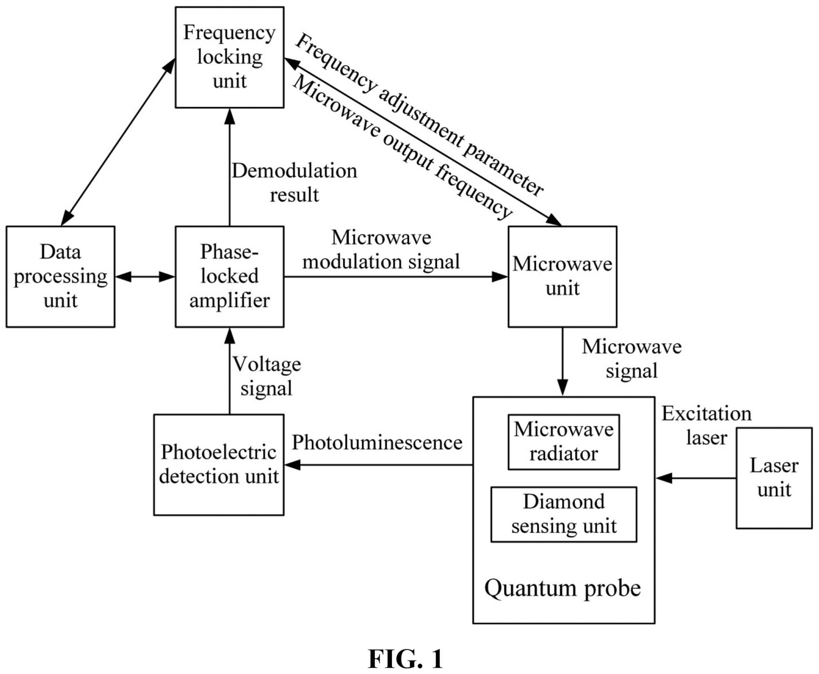

Referring to FIG. 1, this embodiment discloses a quantum sensing module. The quantum sensing module includes a quantum probe, a laser unit, a microwave unit, a photoelectric detection unit, a phase-locked amplifier, a frequency locking unit, and a data processing unit.

In this embodiment, the quantum probe includes a diamond sensing unit and a microwave radiator. The diamond sensing unit is located in a working area of the microwave radiator. The diamond sensing unit includes an NV center. In some examples, the microwave radiator may be a microstrip antenna or a spiral copper wire. The diamond sensing unit is a diamond particle including ensemble NV centers.

In this embodiment, the laser unit is configured to output an excitation laser. The excitation laser is configured to irradiate the diamond sensing unit to cause the diamond sensing unit to produce photoluminescence. In some examples, the wavelength of the excitation laser output by the laser unit is 532 nanometers (nm). Under this laser irradiation, the diamond sensing unit produces red photoluminescence.

In this embodiment, the microwave unit is configured to output a microwave signal. The microwave signal is configured to form a microwave field via the microwave radiator to radiate to the diamond sensing unit. In some examples, the microwave unit includes a microwave source, a microwave amplifier, and a microwave circulator. The microwave source is the emission source of the microwave signal. The microwave amplifier amplifies the microwave power. The microwave circulator prevents reverse transmission of the microwave signal.

In this embodiment, the photoelectric detection unit is configured to receive the photoluminescence produced by the diamond sensing unit and convert the photoluminescence into an output voltage signal. In some examples, the photoelectric detection unit includes a photodiode (such as an avalanche photodiode) and a filtering structure (such as a filter). The photoluminescence directed towards the photodiode is required first pass through the filtering structure to eliminate stray light.

In this embodiment, the phase-locked amplifier includes a modulation unit and a demodulation unit. The modulation unit is configured to output a microwave modulation signal to the microwave unit. The demodulation unit is configured to demodulate the voltage signal and output a demodulation result. In some examples, the phase-locked amplifier is a dual-phase digital demodulator.

In some embodiments, the microwave modulation signal is configured to modulate the microwave signal (for example, frequency modulation or amplitude modulation).

In this embodiment, the frequency locking unit includes a proportional-integral-derivative (PID) control unit and a frequency acquisition unit. The PID control unit is configured to use the demodulation result as an input value and output a frequency adjustment parameter. The frequency adjustment parameter is configured to adjust a microwave output frequency of the microwave unit. The frequency acquisition unit is configured to read the microwave output frequency of the microwave unit. The PID control unit has an input value and a target value. After the input value and the target value are compared, a feedback adjustment parameter can be output, and the input value is adjusted until the input value equals or closely approximates the target value. In this embodiment, the demodulation result output by the phase-locked amplifier can be used as the input value of the PID control unit.

In some embodiments, the data processing unit is configured to be communicatively connected to the frequency locking unit and the phase-locked amplifier and perform data analysis processing on a target program. The target program refers to a program that implements certain functions or algorithms. The target program may be set according to the actual data processing requirements.

In this embodiment, the data processing unit is configured to perform data analysis and processing. For example, the data processing unit is included in a host computer and includes at least a program method for calculating the magnetic field based on the microwave resonance frequency as well as a function unit for generating an ODMR spectrum.

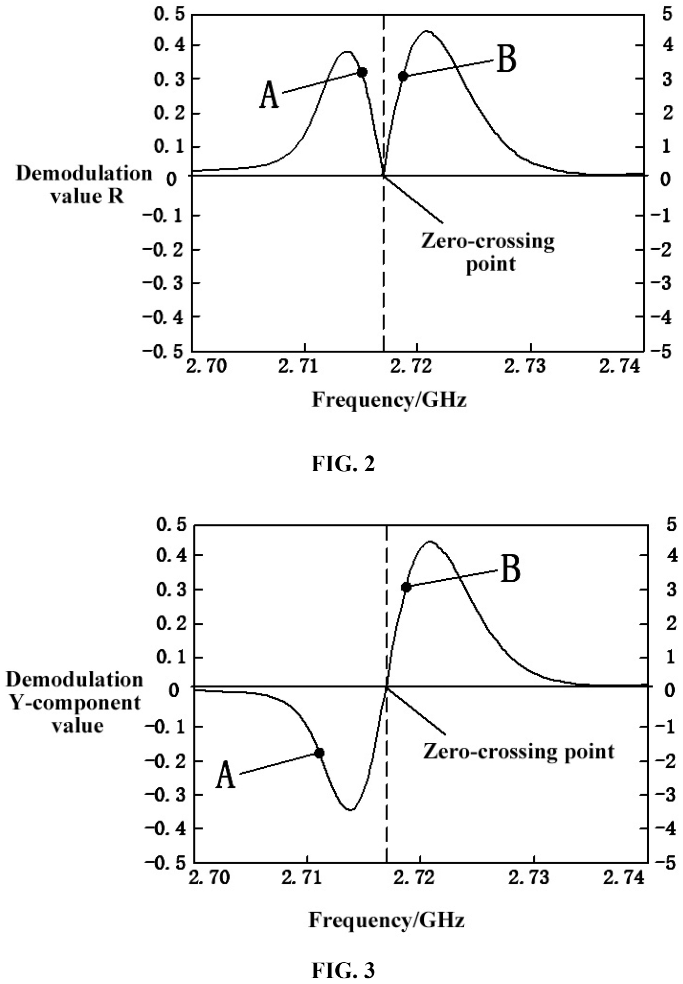

To facilitate an understanding of the role of the PID control unit in this embodiment, an illustrative description is provided. When performing ODMR measurement on diamond NV centers using frequency-swept microwaves, the resulting photoluminescence is converted into a voltage signal by the photoelectric detection unit and sent to the phase-locked amplifier. After demodulation using a dual-phase digital demodulation method (with the microwave modulation signal set as a frequency-modulated signal), a demodulation result (demodulation value R, demodulation X-component value, demodulation Y-component value, and phase value) is obtained. When an ODMR spectrum is constructed with different demodulation results and microwave frequencies as the vertical axis and the horizontal axis, a spectrum as shown in FIG. 2 (with the demodulation value R as the vertical axis) or FIG. 3 (with the demodulation Y-component value as the vertical axis) can be obtained. By analyzing the spectrum, it is evident that the magnetic resonance feature points are all zero-crossing points. Therefore, when switching magnetic fields, the only requirement is to adjust the vertical axis to zero to find the microwave resonance frequency (that is, the horizontal axis at the zero-crossing point) under the current magnetic field. Setting the target value of the PID control unit to 0 enables rapid locking of the microwave resonance frequency (quickly switching from the microwave resonance frequency of the previous magnetic field to the microwave resonance frequency of the next magnetic field). This method of obtaining microwave resonance frequencies does not require broad-range frequency sweeping to plot the ODMR spectrum, significantly improving the speed of microwave resonance frequency acquisition, thereby enhancing the magnetic field measurement efficiency.

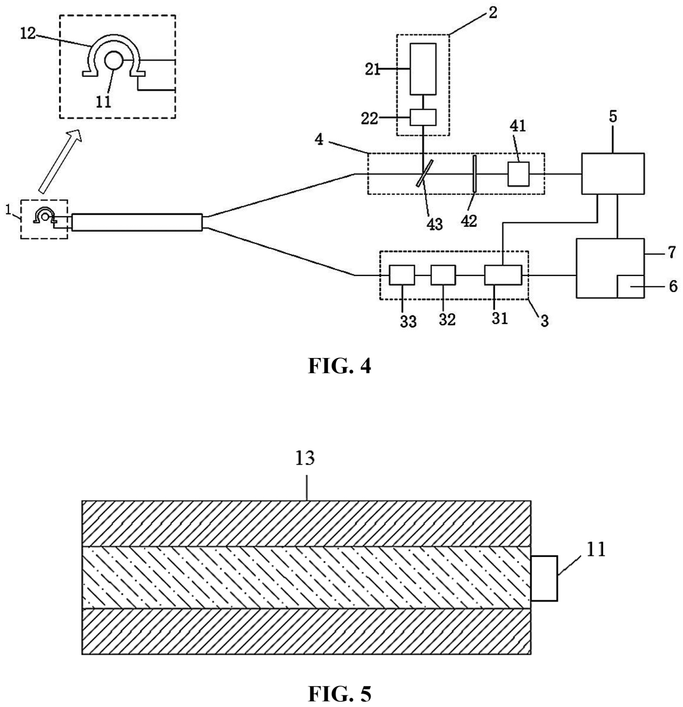

An example structural design of a quantum sensing module is described here. As shown in FIG. 4, the quantum sensing module includes a quantum probe 1, a laser unit 2, a microwave unit 3, a photoelectric detection unit 4, a phase-locked amplifier 5, a frequency locking unit 6, and a data processing unit 7. The quantum probe 1 includes a diamond sensing unit 11 and a microwave radiator 12. The laser unit 2 includes a 532-nm laser 21 and an optical modulator 22. The microwave unit 3 includes a microwave source 31, a microwave amplifier 32, and a microwave circulator 33. The photoelectric detection unit 4 includes a photodiode 41, a filter 42, and a dichroic mirror 43. The connection mode of these components is as shown in the figure (this structure should also include some essential basic connectors, such as optical fibers, optical fiber couplers, and electrical signal transmission cables). Based on the connection mode of these components, the following working process is formed: The laser 21 is activated to generate 532-nm laser light. The laser light is modulated by the optical modulator 22, reflected by the dichroic mirror 43 (red-transmitting and blue-reflecting dichroic mirror), coupled into the optical fiber, and then transmitted to the diamond sensing unit 11. The microwave source 31 outputs a microwave signal. The microwave signal sequentially passes through the microwave amplifier 32 and the microwave circulator 33 and finally is transmitted via a radio-frequency transmission line to the microwave radiator 12. The microwave radiator 12 radiates the microwave signal to the diamond sensing unit 11 in the form of a field. Under the dual influence of the microwave and the laser, the diamond sensing unit 11 generates red photoluminescence. The photoluminescence returns along the path, passes through the dichroic mirror 43, and is filtered by the filter 42 to eliminate stray light. The remaining light is received by the photodiode 41 and converted into an electrical signal. The electrical signal is transmitted to the phase-locked amplifier 5 and demodulated (the phase-locked amplifier 5 also modulates the microwave source 31). The demodulation result is transmitted to the frequency locking unit 6. When the external magnetic field changes, the frequency locking unit 6 is able to quickly lock onto the corresponding microwave resonance frequency. The data processing unit 7 processes the microwave resonance frequency to obtain the to-be-measured physical quantity.

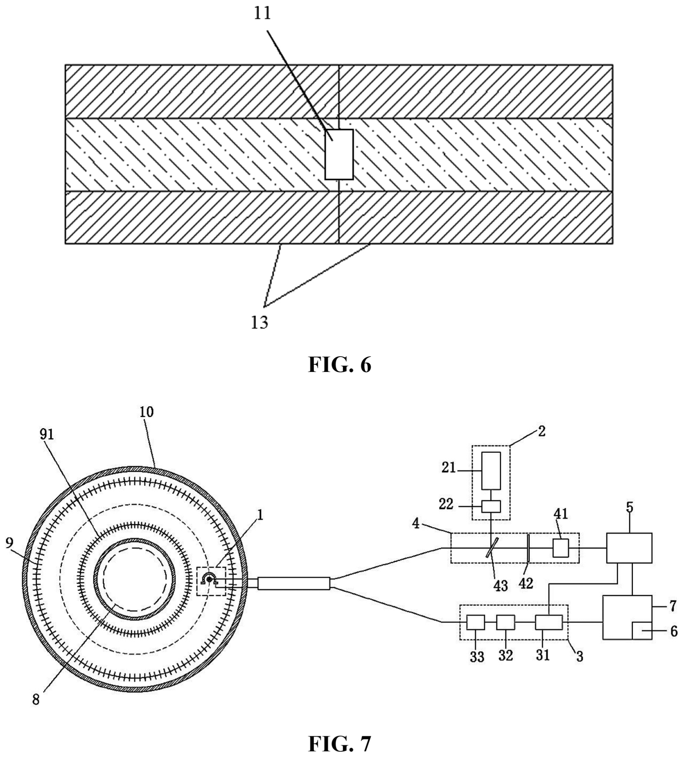

The quantum probe of Embodiment one involves various modes for laser excitation and photoluminescence collection of the diamond sensing unit 11. In some examples, as shown in FIG. 5, the quantum probe 1 includes a transmission optical fiber 13 (that is, input/output optical fiber), with the diamond sensing unit 11 mounted on the optically conductive area at one end of the transmission optical fiber 13. In this structure, both the excitation laser for exciting the diamond sensing unit 11 and the photoluminescence produced by the diamond sensing unit 11 are transmitted by the same transmission optical fiber 13, and the optical excitation process and the collection process are both achieved through the same end. Alternatively, as shown in FIG. 6, the quantum probe 1 includes two transmission optical fibers 13. The two transmission optical fibers 13 are fused. The diamond sensing unit 11 is mounted on the fused interface between the two transmission optical fibers 13. In this structure, the excitation laser is transmitted from one transmission optical fiber 13 to the diamond sensing unit 11, and the photoluminescence is transmitted from the other transmission optical fiber 13 to the photoelectric detection unit 4.

In some examples, the phase-locked amplifier is a dual-phase digital demodulator. The demodulation result obtained through the dual-phase digital demodulator includes the demodulation value R, demodulation X-component value, demodulation Y-component value, and phase value. In some examples, a phase auto-adjusting unit is also included. The phase auto-adjusting unit is configured to automatically adjust the initial phase of the phase-locked amplifier according to a set target. When using a dual-phase digital phase-locked amplifier for modulation and demodulation and when plotting an ODMR spectrum as shown in FIG. 3 (with the demodulation Y-component value as the vertical axis), an initial phase adjustment is required (that is, phase adjustment is required so that the demodulation X-component value approaches zero) to obtain a more accurate measurement result. For example, the initial phase may be manually adjusted continuously while monitoring whether one of the component values satisfies the set target. This manual adjustment process is relatively low in automation, so the adjustment has been automated in a software program. In an example, the set target may be: to make the demodulation X-component value or Y-component value equal to zero or close to zero (that is, near zero). Based on this set target, the software program continuously adjusts the initial phase and completes the closed-loop process by determining whether the set target has been achieved. The programming for this process is relatively simple.

Embodiment one involves measurement of a magnetic field. Considering the conversion relationship between electromagnetism, the present application also provides embodiment two for measurement of a current.

### Embodiment two

As shown in FIG. 7, this embodiment discloses a quantum current transformer configured to measure the current in a conductor. The quantum current transformer includes one or more quantum sensing modules as described in Embodiment one (for ease of presentation, the structure of the quantum sensing module in FIG. 7 is the same as that shown in FIG. 4; however, it is to be understood that the structure of the quantum sensing module in this embodiment is not limited to this). The quantum current transformer also includes a conductor channel 8. An external magnetic shield 9 is disposed on the outer side of the conductor channel 8. The diamond sensing unit 11 is disposed on a virtual ring between the conductor channel 8 and the external magnetic shield 9.

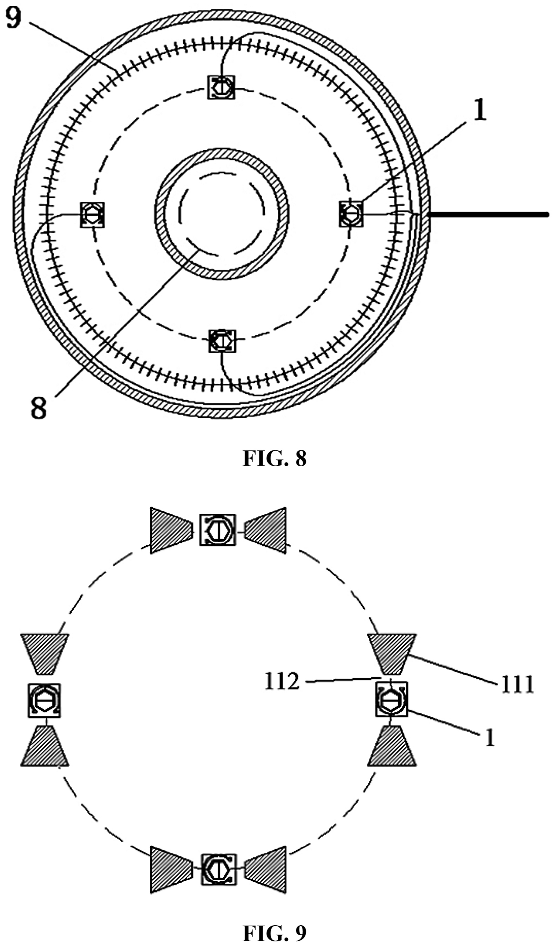

As shown in FIG. 8, multiple quantum sensing modules are disposed in the quantum current transformer, and all diamond sensing units are configured to be evenly spaced on the virtual ring.

In an embodiment, when the quantum current transformer includes multiple quantum sensing modules, since each quantum sensing module includes a quantum probe 1, and the quantum probe 1 includes a diamond sensing unit 11 and a microwave radiator 12. Therefore, there are multiple diamond sensing units 11. In the case where there are multiple diamond sensing units 11, all of the diamond sensing units 11 are configured to be evenly spaced on the virtual ring. As shown in FIG. 8, four diamond sensing units 11 are configured to be evenly spaced on the virtual ring.

Considering the mechanism of noise suppression of magnetic measurement by loop integration, in an embodiment, when the quantum current transformer includes multiple quantum sensing modules, there are 4n quantum sensing modules. Here n is a positive integer. For example, when n is 1 or 2, after summed up and averaged, the magnetic field information measured by the multiple quantum sensing modules can effectively eliminate an external magnetic field, thereby improving the accuracy of current measurement.

In some embodiments, the diamond sensing unit used in the quantum current transformer is a diamond particle including ensemble NV centers. Such a diamond sensing unit can produce a stronger photoluminescence excitation effect, facilitating the collection of photoluminescence data. The ensemble NV centers have four types of NV center axes. Based on the interaction between the magnetic fields in different directions and the four NV center axes, various peak shapes (2 peaks, 4 peaks, 6 peaks, or 8 peaks) are formed on the ODMR spectrum.

For a two-peak ODMR spectrum, the number of peaks is relatively small, meaning that fewer microwave resonance frequencies are to be locked and tracked, resulting in lower difficulty and faster locking speed. This makes it ideal for situations that require rapid acquisition of current measurement results. In some examples, angles between four NV center axes of the diamond sensing unit and a tangent to the virtual ring at a point where the diamond particle is located are made consistent. This results in a two-peak ODMR spectrum.

For an eight-peak ODMR spectrum, based on the relationship between the components of the multi-directional axes and the magnetic field, vector measurement of the magnetic field can be achieved. In this case, although more microwave resonance frequencies need to be locked and tracked, the vector measurement yields a current result that can satisfy certain detection requirements. In other examples, angles between four NV center axes of the diamond sensing unit and a tangent to the virtual ring at a point where the diamond particle is located are made different. This results in an eight-peak ODMR spectrum.

Considering the complexity of the current detection environment, such as a scenario involving a small current (where the magnetic field generated by the energized conductor is comparable to the external interference magnetic field), to improve the accuracy of current measurement, in some embodiments, as shown in FIG. 9 (the case with four quantum probes), the quantum current transformer is additionally provided with a magnetic concentrator 111. The diamond sensing unit 11 is disposed in a magnetic gap 112 of the magnetic concentrator 111. The magnetic concentrator 111 amplifies the magnetic field generated by the to-be-measured energized conductor and reduces the influence of an external magnetic field, thereby improving the accuracy of current measurement.

To improve the ability of the device to suppress the interference of an external magnetic field, in some embodiments, as shown in FIG. 7, an inner magnetic shield 91 is also provided. The diamond sensing unit 11 is disposed on the outer side of the inner magnetic shield 91. The cooperation between the inner magnetic shield 91 and the outer magnetic shield 9 better enhances the noise reduction capability of the device.

In some scenarios, additional magnetic fields are required for initial calibration or corresponding testing of the quantum current transformer. In some embodiments, the quantum current transformer is also provided with a bias magnetic source. The bias magnetic source is configured to apply a bias magnetic field at any angle to the diamond sensing unit. The bias magnetic source may be either a permanent magnet or an energized coil.

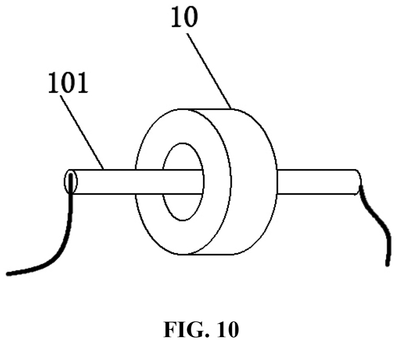

Considering practical use, as shown in FIGS. 7 and 8, the quantum current transformer also includes a primary ring 10. The conductor channel 8 is located in the inner hole of the primary ring 10. The external magnetic shield 9 and the diamond sensing unit 11 are both located in the inner cavity of the primary ring 10. The primary ring 10 only to facilitates the mounting of some front-end components but also provides excellent protection. In some embodiments, as shown in FIG. 10, the quantum current transformer also includes a conductor rod 101. The central axis of the conductor rod 101 coincides with the central axis of the inner hole of the primary ring 10. Moreover, the central axis of the conductor rod 101 is perpendicular to and intersects the center of the virtual ring, meaning that each quantum probe 1 is equidistant from the conductor rod 101, ensuring consistency in the measurement of the magnetic field of the conductor. In some embodiments, the primary ring 10 is disposed at the top of an insulator. A cable channel is formed in the insulator and passes through the upper side and the lower side of the insulator. The cable channel is configured to accommodate transmission components such as optical fibers and electrical wires.

According to another aspect of the present application, a current measurement method is provided. The current measurement method is applied to the quantum current transformer. The current measurement method includes initial parameter acquisition and conductor current measurement.

The initial parameter acquisition includes outputting, by the microwave unit, a frequency-swept microwave signal, plotting an ODMR spectrum of the quantum probe based on the frequency-swept microwave signal, acquiring a microwave resonance frequency at a magnetic resonance feature point on the ODMR spectrum, and recording the microwave resonance frequency as an initial microwave frequency.

In the step of initial parameter acquisition, the diamond sensing unit outputs feedback photoluminescence under the combined action of the swept-frequency microwave signal and the laser signal. By processing and mapping based on the detected signal, the target ODMR spectrum can be obtained. The shape of the target ODMR spectrum can generally take one of two forms: one where the magnetic resonance feature point is a zero-crossing point (with the swept-frequency microwave modulated) and the other where the magnetic resonance feature point is a peak point (without modulation of the swept-frequency microwave). In this step, the PID control unit has not yet started to function. After obtaining the swept-frequency ODMR spectrum, the microwave resonance frequency may be manually selected or may be automatically acquired using a software program. In this case, the quantum current transformer also includes a feature point auto-acquisition unit. The feature point auto-acquisition unit is configured to automatically identify the magnetic resonance feature point on the ODMR spectrum and acquire the microwave resonance frequency at the magnetic resonance feature point.

Based on the ODMR spectrum under frequency modulation, it can be known from analysis that the microwave resonance frequency of any magnetic field corresponds to the zero-crossing point on the horizontal axis of the ODMR spectrum under frequency modulation. Therefore, it is possible to quickly lock the microwave resonance frequency of the next magnetic field by setting the locking condition based on the zero-crossing point. Of course, the prerequisite is that the starting microwave resonance frequency that matches the current diamond sensing unit is available. This is the actual function of the step of initial parameter acquisition.

The conductor current measurement includes outputting, by the microwave unit, a fixed-frequency microwave signal at the initial microwave frequency; outputting, by the phase-locked amplifier, a frequency-modulated signal and modulating the fixed-frequency microwave signal by using the frequency-modulated signal; activating the quantum current transformer based on the fixed-frequency microwave signal to perform ODMR measurement; measuring, by the quantum current transformer, a magnetic field generated by a to-be-measured energized conductor and acquiring a demodulation result; performing, by the PID control unit, feedback adjustment on the microwave unit based on the demodulation result and a target value such that the microwave output frequency of the microwave unit is switched to an available resonance frequency that characterizes the magnetic field generated by the energized conductor; capturing, by the frequency acquisition unit, the available resonance frequency and transmitting the available resonance frequency to the data processing unit; and analyzing and processing, by the data processing unit, the available resonance frequency to obtain current information in the to-be-measured energized conductor.

During conductor current measurement, there is no need to use a frequency-swept microwave. Instead, a fixed-frequency microwave signal (that is, the initial microwave frequency obtained in the previous step) is used in combination with the laser signal. The PID control unit tracks the starting fixed-frequency microwave signal. When the external magnetic field changes, the PID control unit enables rapid locking of the microwave resonance frequency, thereby allowing for quick current measurement.

In the preceding current measurement scheme, it is stated that the demodulation result is compared with the target data to obtain the frequency adjustment parameter. The expression of the demodulation result varies with different demodulation modes. For instance, in single-phase demodulation, the demodulation result includes only the demodulation value R (non-negative); and in dual-phase demodulation, the demodulation result includes the demodulation value R (non-negative), demodulation X-component value, demodulation Y-component value, and phase value.

The ODMR spectrum constructed using the demodulation value R and the microwave frequency is shown in FIG. 2. When the demodulation value R is used as the input to the PID control unit and compared with the target value, and the spectrum is analyzed, the new magnetic resonance feature point is at the zero-crossing point (which is the target that the PID control unit locks onto, typically set to 0) when the magnetic field switches. The magnetic resonance feature point of the previous magnetic field is at point A (or point B). To move the magnetic resonance feature point from point A (or point B) to the zero-crossing point, a frequency adjustment parameter needs to be provided. If the magnetic resonance feature point is at point A, a positive frequency adjustment parameter should be set to increase the microwave signal frequency. If the magnetic resonance feature point is at point B, a negative frequency adjustment parameter should be set to decrease the microwave signal frequency. Therefore, when outputting the frequency adjustment parameter, it is also necessary to determine the direction of feedback adjustment. A conventional solution is to randomly apply a positive (or negative) frequency adjustment parameter and then check if the adjusted demodulation result is closer to the zero-crossing point. If yes, the positive (or negative) frequency adjustment parameter continues being applied until the frequency locking process is completed. If not, a negative (or positive) frequency adjustment parameter is applied to adjust the frequency. This frequency adjustment method requires determining the direction of the adjustment, resulting in a longer frequency adjustment time and a bandwidth limitation. (For example, as shown in FIG. 2, this adjustment step can be applied to only the part between the two peak values of the waveform.)

Since the direction of the microwave signal feedback adjustment needs to be considered, extra time is required for the frequency locking process, thus affecting the overall measurement speed of the system.

To improve the feedback adjustment efficiency of the PID control unit, the following example scheme is proposed:

In the step of conductor current measurement, the photoelectric detection unit outputs a voltage signal that represents the voltage signal of the magnetic field generated by the to-be-measured conductor, and the voltage signal is demodulated using the dual-phase digital demodulation method.

The phase adjustment makes one of the two demodulated component values close to zero. The other component value as the input to the PID control unit is compared with the target value to obtain the frequency adjustment parameter of the microwave signal.

In an example scheme, a dual-phase digital phase-locked amplifier is used. The dual-phase digital phase-locked amplifier demodulates the voltage signal via dual-phase digital demodulation. The demodulation result includes the demodulation value R, demodulation X-component value, demodulation Y-component value, and phase value. The phase (that refers to the phase of the frequency modulation signal or the phase of the reference signal) of the dual-phase digital phase-locked amplifier is adjusted such that the demodulation X-component value (or demodulation Y-component value) becomes zero. The demodulation Y-component value (or demodulation X-component value) is used as the input value to the PID control unit. The target value is set. The input value is compared with the target value, a frequency adjustment parameter is output, and a microwave signal output from the microwave source is adjusted.

The demodulation X-component value is set to zero. The demodulation Y-component value is used as the input value to the PID control unit. The target value is set to zero. In this case, an ODMR spectrum is constructed using the demodulation Y-component value and the microwave frequency, as shown in FIG. 3. When the magnetic field changes, the new magnetic resonance feature point corresponds to the zero-crossing point in the figure (the zero-crossing point is the target locked by the PID control unit, and when the demodulation result is zero, it means the magnetic resonance point, so the target value is typically set to zero). The magnetic resonance feature point of the previous magnetic field is point A (or point B). To move the magnetic resonance feature point from point A (or point B) to the zero-crossing point, it is required to provide a frequency adjustment parameter. It can be seen from an analysis of the spectrum shown in FIG. 3 that the demodulation Y-component value has positive and negative values before and after the zero-crossing point. Therefore, when the demodulation Y-component value is greater than zero, it is required to reduce the microwave signal frequency; otherwise, it is required to increase the microwave signal frequency. This feedback adjustment method is faster and more efficient, significantly reducing the adjustment time of the PID control unit, improving the overall measurement speed of the quantum current transformer, and broadening the measurement bandwidth.

In the preceding scheme, it is mentioned that the initial phase is adjusted so that one of the demodulated component values is close to zero. The term "close to zero" can be defined as exactly zero or be defined as a value that fluctuates slightly around zero (with the fluctuation amplitude limited to less than 10% of the component value). For example, it is feasible to manually adjust the initial phase while monitoring the selected component value in real time to check if the component value reaches zero; or it is feasible to automatically adjust the phase by using a software program. In this case, the quantum current transformer also includes a phase auto-adjusting unit. The phase auto-adjusting unit is configured to automatically adjust the initial phase of the phase-locked amplifier according to a set target.

In some embodiments, it is not required to plot an ODMR frequency-swept spectrum for each measurement of the magnetic field. Instead, it is possible to quickly track the changing magnetic resonance frequency by comparing the target data with the demodulation result, thereby significantly reducing the time required to acquire a new magnetic resonance frequency and enhancing the measurement speed of the quantum current transformer.

In a description of this specification, the description of reference terms "an embodiment" and "example" is intended to be included in at least one of embodiments or examples of the present application in connection with specific characteristics, structures, materials or features described in this embodiment or example. In the specification, the illustrative description of the preceding terms does not necessarily refer to the same embodiment or example.

## Claims

1. A quantum sensing module, comprising:
a quantum probe comprising a diamond sensing unit and a microwave radiator, wherein the diamond sensing unit is located in a working area of the microwave radiator, and the diamond sensing unit comprises a nitrogen-vacancy, NV, center;
a laser unit configured to output an excitation laser, wherein the excitation laser is used to irradiate the diamond sensing unit to cause the diamond sensing unit to produce photoluminescence;
a microwave unit configured to output a microwave signal, wherein the microwave signal is used to form a microwave field via the microwave radiator to radiate to the diamond sensing unit;
a photoelectric detection unit configured to receive the photoluminescence produced by the diamond sensing unit and convert the photoluminescence into an output voltage signal;
a phase-locked amplifier comprising a modulation unit and a demodulation unit, wherein the modulation unit is configured to output a microwave modulation signal to the microwave unit, the microwave modulation signal is used to modulate the microwave signal, and the demodulation unit is configured to demodulate the voltage signal and output a demodulation result;
a frequency locking unit comprising a proportional-integral-derivative, PID, control unit and a frequency acquisition unit, wherein the PID control unit is configured to use the demodulation result as an input value and output a frequency adjustment parameter, the frequency adjustment parameter is used to adjust a microwave output frequency of the microwave unit, and the frequency acquisition unit is configured to read the microwave output frequency of the microwave unit; and
a data processing unit configured to be communicatively connected to the frequency locking unit and the phase-locked amplifier and perform data analysis processing on a target program.

2. The quantum sensing module of claim 1, wherein
the quantum probe comprises a transmission optical fiber, and the diamond sensing unit is mounted on a light transmission region at one end face of the transmission optical fiber; or
the quantum probe comprises two transmission optical fibers that are fused into a single unit, and the diamond sensing unit is mounted on a fused face between the two transmission optical fibers.

3. The quantum sensing module of claim 1, wherein the phase-locked amplifier is a dual-phase digital demodulator.

4. A quantum current transformer, configured to measure a current in a conductor, comprising:
the quantum sensing module of any one of claims 1 to 3, and
a conductor channel, wherein an external magnetic shield is disposed on an outer side of the conductor channel, and the diamond sensing unit is disposed on a virtual ring between the conductor channel and the external magnetic shield.

5. The quantum current transformer of claim 4, wherein a plurality of quantum sensing modules are provided, and all diamond sensing units of the plurality of quantum sensing modules are configured to be evenly spaced on the virtual ring.

6. The quantum current transformer of claim 4 or 5, wherein the diamond sensing unit is a diamond particle including ensemble NV centers, and angles between four NV center axes of the diamond sensing unit and a tangent to the virtual ring at a point where the diamond particle is located are consistent or unequal to each other.

7. The quantum current transformer of claim 4 or 5, further comprising a magnetic concentrator, wherein the diamond sensing unit is disposed in a magnetic gap of the magnetic concentrator.

8. The quantum current transformer of claim 5, wherein 4n quantum sensing modules are provided, wherein n is a positive integer.

9. The quantum current transformer of claim 4 or 5, wherein an internal magnetic shield is also disposed on the outer side of the conductor channel, and the diamond sensing unit is disposed on an outer side of the internal magnetic shield.

10. The quantum current transformer of claim 4 or 5, further comprising a bias magnetic source, wherein the bias magnetic source is configured to apply a bias magnetic field at any angle to the diamond sensing unit.

11. The quantum current transformer of claim 4 or 5, further comprising a primary ring, wherein the conductor channel is located in an inner hole of the primary ring, and the external magnetic shield and the diamond sensing unit are located in an inner cavity of the primary ring.

12. The quantum current transformer of claim 11, further comprising a conductor rod, wherein a central axis of the conductor rod coincides with a central axis of the inner hole of the primary ring, and the central axis of the conductor rod is perpendicular to and intersects a center of the virtual ring.

13. The quantum current transformer of claim 11, further comprising an insulator, wherein the primary ring is disposed at a top of the insulator, and a cable channel is formed in the insulator and passes through an upper side and a lower side of the insulator.

14. A current measurement method, the method being applied to the quantum current transformer of any one of claims 4 to 13 and the method comprising:
an initial parameter acquisition operation which comprises: outputting, by the microwave unit, a frequency-swept microwave signal, plotting an optical detection magnetic resonance, ODMR, spectrum of the quantum probe based on the frequency-swept microwave signal, acquiring a microwave resonance frequency at a magnetic resonance feature point on the ODMR spectrum, and recording the microwave resonance frequency as an initial microwave frequency; and
a conductor current measurement operation which comprises: outputting, by the microwave unit, a fixed-frequency microwave signal at the initial microwave frequency; outputting, by the phase-locked amplifier, a frequency-modulated signal and modulating the fixed-frequency microwave signal by using the frequency-modulated signal; activating the quantum current transformer based on the fixed-frequency microwave signal to perform ODMR measurement; measuring, by the quantum current transformer, a magnetic field generated by a to-be-measured energized conductor and acquiring a demodulation result; performing, by the PID control unit, feedback adjustment on the microwave unit based on the demodulation result and a target value such that the microwave output frequency of the microwave unit is switched to an available resonance frequency that characterizes the magnetic field generated by the energized conductor; capturing, by the frequency acquisition unit, the available resonance frequency and transmitting the available resonance frequency to the data processing unit; and analyzing and processing, by the data processing unit, the available resonance frequency to obtain current information in the to-be-measured energized conductor.

15. The current measurement method of claim 14, wherein acquiring the demodulation result comprises:
outputting, by the photoelectric detection unit, a voltage signal that characterizes the magnetic field generated by the to-be-measured energized conductor; and
demodulating the voltage signal by using a dual-phase digital demodulation method to acquire the demodulation result, performing phase adjustment such that one of two demodulated component values is approximately zero, comparing the other of the component values with the target value, wherein the other of the component values serves as the input value of the PID control unit, and outputting the frequency adjustment parameter for adjusting the microwave unit.

16. The current measurement method of claim 15, further comprising:
automatically adjusting, by a phase auto-adjusting unit of the quantum current transformer, an initial phase of the phase-locked amplifier according to a set target.

17. The current measurement method of claim 14, further comprising:
automatically identifying, by a feature point auto-acquisition unit of the quantum current transformer, the magnetic resonance feature point on the ODMR spectrum and acquiring the microwave resonance frequency at the magnetic resonance feature point.
